# EUROPEAN PATENT APPLICATION

(11) **EP 2 290 684 A1**
(43) Date of publication of application: **02.03.2011**
(21) Application number: 09169154.3
(22) Date of filing: 01.09.2009
(51) Int. Cl.: H01L 23/552, H01L 31/0216, H01L 23/58

(54) **Method to provide a protective layer on an integrated circuit and integrated circuit fabricated according to said method**

(71) Applicant: Microdul AG, 8045 Zürich (CH)
(72) Inventor: De Zaldivar, José Solo, 8820 Wädenswil (CH); Poole, Philip John, 8874 Mühlehorn (CH)
(74) Representative: Liebetanz, Michael

(57) **Abstract**

A method to provide at least one protective, especially a light-shielding, layer (2) on an integrated circuit (10) applies the protective metal layer (2) as an additional layer to the integrated circuit (10) after completion of the integrated circuit manufacturing step. This allows for an at least partly shielded integrated circuit comprising a protective layer (2,4), wherein the metallic shielding layer (2) and the overlying polyimide layer (4) are patterned with a different, coarser resolution than the other IC metal interconnection layers.

## Description

### Short Description of the Invention

The invention concerns a method to provide a protective, especially a light-stopping, layer on IC's, according to claim 1 as well as an integrated circuit fabricated according to said method.

### Technical Background of the Invention

It is known from JP 58 222 546 that a thin metal layer can be used for wiring and that such layers can also be used in a light-shielding procedure. When a multilayer wiring structure is formed, gaps in each layer are filled with wires of the other layers, to shield incoming light beams. In other words, the light beam is shielded by at least one of the metal wires from the first, second or third layers.

From JP 58 10 7671 it is also known that a complete metal layer can be sacrificed to shield light from the active region of an image sensor circuit, instead of using complicated wiring as given in JP 58 222 546.

### Summary of the Invention

The prior art shows the use of metal wires, constructed to collectively block light. Using this technique, a small amount of light will still propagate to the active surface, due to refraction and reflection, because said wires are not in the same plane.

Additionally, the metal wires or metal layers used in these prior art documents are provided in the IC manufacturing process. Applying metal layers in the IC-manufacturing process is very costly because of the large resolution and high alignment accuracy needed to define the very small structures used in the interconnection layers.

The invention is based on the insight that the intended result of light-shielding can also be achieved after the integrated circuit manufacturing steps, i.e. after completion of the integrated circuit, e.g. in a different lower cost wafer manufacturing environment.

In other words, the technique mentioned in the prior art is only applicable to the technology of fabrication as mentioned, since it uses one or more of the interconnection technology layers.

The present application suggests the application of light shielding layers, after the IC-fabrication, in other words in a specific additional production step in the manufacturing process. This has the advantage of being technologically independent of the baseline manufacturing process in the IC diffusion factory.

For the time being, the prior art uses one of the interconnection layers in the IC-manufacture, which is quite expensive, since one interconnection layer is sacrificed.

The invention provides the specific additional metal layer after the completion of the integrated circuit, e.g. in the bumping factory, and thus uses much cheaper equipment and a cheaper wafer process. Additionally, this process can be applied for any chip handled in the bump factory, and is therefore independent of the IC wafer technology. Another advantage of the technology is the fact that it selectively protects against light, because the additional metal layer can be patterned, using a photo-resist and etching process. In this sense, it is possible to apply selective protection against light, even in cases, where this was not originally foreseen during the IC-manufacture. In other words, the light shielding layer is an additional layer which is provided after the completion of the IC wafer manufacturing process in a wafer factory using photolithography equipment of much lower resolution than that one needed in the IC wafer manufacturing process. Said different resolution is clearly visible, when the additional shielding layer is itself patterned, but it is also recognizable by someone skilled in the art within the finished light-shielded integrated circuit, since the outer borders of the light shielding layer reflect said different resolution.

### Short description of the drawings

The invention will now be described in connection with the enclosed drawings, showing embodiments of the invention.
- Fig. 1: shows a finished integrated circuit, provided for apply- ing the method according to the invention;
- Fig. 2: shows the wafer of figure 1, with a metal layer deposited on the whole circuit;
- Fig. 3: shows the wafer of figure 2, after appliance of the photo-resist pattern;
- Fig. 4: shows the wafer of figure 3 after a wet metal etching step;
- Fig. 5: shows a view on the integrated circuit layout before the application of the method according to the invention; and
- Fig. 6: shows the integrated circuit of figure 5 after the appli- cation of the method according to the invention.

### Detailed description of preferred embodiments

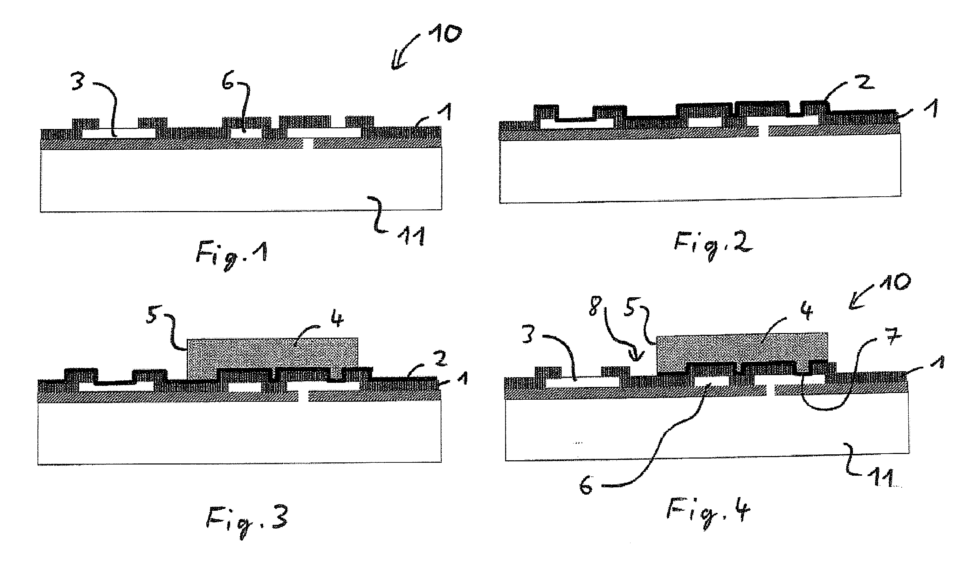

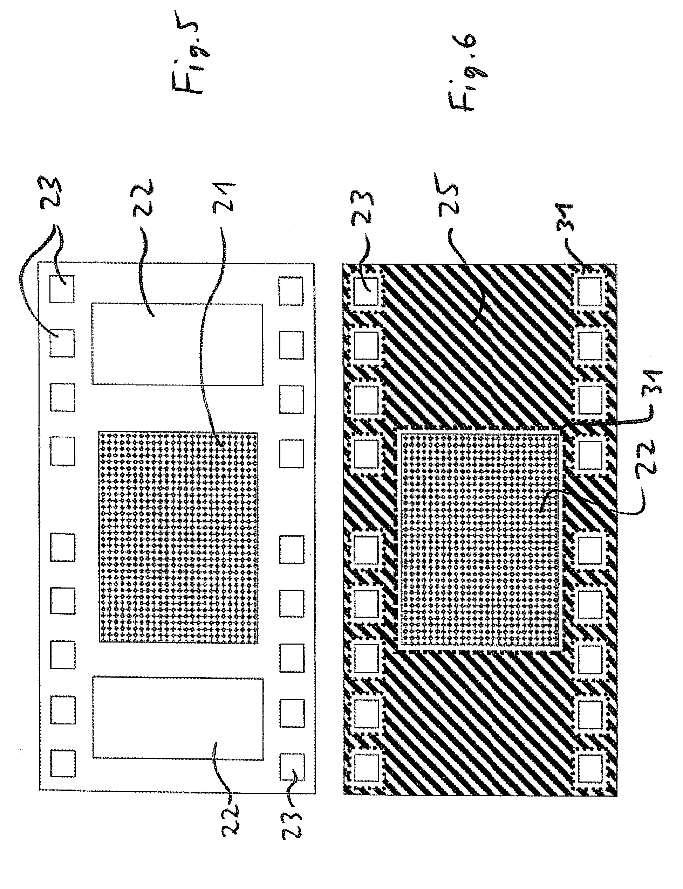

Figure 1 shows a cross section through an integrated circuit in a very schematic way, and figure 5 shows a view on such an integrated circuit from above.

Said integrated circuit 10 is thus a chip, especially an optical sensor chip, produced in an IC-factory, having a given resolution on the IC-wafer 11.

IC-chips that have been manufactured on wafers in the wafer factory are, according to the invention, post-processed in a different production line where the resolution of the method described here is lower than the resolution in the IC fabrication line. The application of the layer in this later stage has therefore the advantage that it is less costly and that it will be compatible with the baseline technology, to avoid any detrimental influencing on device parameters and on the reliability of the integrated circuit. However, in view of photo-sensor integrated circuits, where only part of the chip, the photodiode, is later intended to be exposed to light, application of the light stopping layer protecting the logic and analogue areas of the chip can be provided by using a much coarser resolution.

The light stopping layer can still be selectively placed on the integrated circuit, and the material used for the light stopping layer will reflect a large spectrum of the incident light, for example from UV (350 nm) to IR (1200 nm). However, the resolution on the surface of the chip is a factor of 10 coarser than in the IC-fabrication.

The steps of the invention can therefore be applied to the formation of a light stopping layer on integrated circuit wafers 11, in technologies like CMOS, Bipolar, BiCMOS and CCD, with or without gold or solder bumps.

The method can also be applied to technologies with bumps redistribution.

Figure 2 shows the wafer of figure 1, after positioning of a metal layer 2 on the passivation layer 1, whereas the bonding pad 3, as well as the optical sensor arrays are open. The metal is preferably Ti. The metal deposition is preferably done by metal-sputtering, but it can also be deposited by metal electron-gun evaporation.

Figure 3 shows the application of a photo-sensitive organic layer 4, having appropriate properties. These properties are: high-specific resistance, a good adhesion to the metal layer 2 (e.g. Ti), able to provide a sufficient mechanical protection, as well as appropriate dielectric properties. One preferred solution comprises the use of a polyimide photo-sensitive layer (Pi), which is normally used as a dielectric layer between metal-interconnecting levels in the IC-wafer manufacturing. However, it is noted that the embodiment according to the invention is using the application of this organic layer 4 in the context of a bumping factory. Therefore, the sidewall 5 of this organic layer 4 has not to be so precisely positioned (lower alignment accuracy) as the wiring 6 in the figures. However, this does not matter, as long as the wall 5 is positioned between the bond pads to be opened 3 and the metallic wires 6 to be protected. Therefore an open area 8 only covered by the passivation layer remains between the zone covered by the protective metal layer 2 and the open bonding pads 3.

Then, the resist 4 is submitted to a light-exposure and subsequent development. Finally, as is shown in figure 4, a wet metal etching step is applied, which means that an organic solution is used to remove the metal layer (Ti) selectively on Si3N4, Si02, or Al (which is used as pads on the integrated circuit)

Finally, as can be seen with reference numeral 7 in figure 4, the metal plate uses as light stopping layer 2 has to be connected to ground, in order to prevent charging during the manufacturing process. Figure 4 shows such a contact.

The advantages of this method are:
- the process described is perfectly compatible with most IC-wafer processes. This compatibility is achieved in terms of materials, reliability, and stability of the device parameters. There will be no deterioration of original values of device parameters like transistors, capacitors, or resistors. No introduction of radiation damage can negatively influence the reliability of the IC-components.

The metal layer 2 itself is protected by a thick Pi-layer 4 (polyimide layer), which remains on the wafer 11. This Pi-layer can preferably have a thickness of 2 µm, 4 µm or more than 4 µm, which is quite larger than the protection layers which can be achieved within the IC-manufacturing process. This is an additional advantage, moving the production of the shielding layer 2 to a bumps factory. Said Pi-layer protects against mechanical damage, as well as against contaminants from the environment. In the case of the photo-sensor chip according to figure 5 and 6, only the photo-transistor matrix 21 and the pads 23 are open. The remaining area 25 of the integrated circuit is protected by the Ti- and Pi-layers.

Figure 5 shows a view on the integrated circuit layout before the application of the method according to the invention comprising a centrally arranged photo-transistor matrix 21. Logic or analog circuitry 22 are arranged in two zones to the left and right of that matrix 21. A plurality of IC connection pads 23 are provided in two rows above and below the circuitries 21 and 22.

Figure 6 shows the integrated circuit of figure 5 after the application of the method according to the invention. The pads 23 and the optical array comprising the photo-transistor matrix 21 are not covered with the metal protecting plate 2 and the covering resist 4. The reference numeral 25 designates the protected area shown in figure 6 as hatched. It is noted that a narrow passivation layer area 31 is still visible around each pad 23 and around the photo-transistor matrix which is not covered by the resist 4 of the protected area 25. This zone 31 is equivalent to the open area 8 of figure 4 and contributes to the advantages of the method according to the invention.

Due to the fact the minimum dimensions to be patterned with a light stopping layer 2 are relatively large (>20 µm); this process can be carried out in the bumping facility with low costs for the lithography equipment, compared to the wafer steppers, used in the IC-manufacturing. This reduces the costs of the additional process steps, as shown in figure 1 to 4, to create the light stopping layer 2.

Ti is the metal of choice, since sputter Ti has a very high adhesion on SiO2 and on Si3N4, which are the usual materials used for the IC-passivation layers 1. Ti sputtering equipment is the preferred system equipment, since it is very commonly used equipment in wafer facilities in bumping production.

The adhesion between Ti- and Pi-layers is excellent, and the Ti is therefore perfectly protected during the whole lifetime of the IC.

It is an additional advantage that the metal plate 2 covering logic analog areas and I/O circuitry 22 represents also an electric shielding, protecting the IC circuitry from electromagnetic interferences and radiation.

Finally, the metal plate 2 made according to the invention can also be used to cover ROM's, EEPROM's and Flash Memories against illegal reading of content in a very cheap and effective way.

### Reference Numerals

- 1: passivation layer
- 2: metal layer
- 3: bonding pad
- 4: organic layer
- 5: metallic wires
- 6: side wall
- 7: ground connection
- 8: open area
- 10: integrated circuit
- 11: wafer
- 21: photo-transistor matrix
- 22: logic or analog circuitry
- 23: IC connection pad
- 25: protected area
- 31: passivation layer area

## Claims

1. Method to provide at least one protective, especially a light-shielding, layer on an integrated circuit, **characterized in that** the protective metal layer is applied as an additional layer to the integrated circuit after completion of the integrated circuit manufacturing step.

2. Method according to claim 1, wherein the protective layer is applied in a bump factory.

3. Method according to claim 1 or 2, wherein the additional protective layer is patterned providing selective protection against light for the integrated circuit.

4. Method according to one of claims 1 to 3, wherein the additional protective layer is applied with a coarser resolution than the resolution needed to manufacture the integrated circuit.

5. Method according to one of claims 1 to 4, wherein the additional protective layer used as light stopping layer is a metal layer connected to ground.

6. Method according to one of claims 1 to 5, wherein the additional protective layer itself is protected by a polyimide layer provided on the protective layer.

7. Method according to one of claims 1 to 6, wherein the additional protective layer is made of Ti, especially sputtered Ti.

8. Method according to one of claims 1 to 7, wherein a plurality of finished integrated circuits is arranged on a wafer for providing said protective layer on said plurality of integrated circuits.

9. At least partly shielded integrated circuit comprising a protective layer (2, 4; 25) provided on an integrated circuit according to a method according to one of claims 1 to 8.

10. Integrated circuit according to claim 9, wherein the protective layer comprises a Ti shielding layer (2) and a polyimide layer (4) provided on the passivation layer (1) of the integrated circuit, wherein the Ti shielding layer (2) and a polyimide layer (4) have a different, coarser resolution than the other IC metal interconnection layers.
